# NEUE EUROPÄISCHE PATENTSCHRIFT

(11) **EP 0 174 578 B2**
(45) Veröffentlichungstag und Bekanntmachung des Hinweises auf die Entscheidung über den Einspruch: **23.06.1993**
(45) Hinweis auf die Patenterteilung: 02.12.1987
(21) Anmeldenummer: 85111043.7
(22) Anmeldetag: 02.09.1985
(51) Int. Cl.: H01R 13/719, H03H 1/00

(54) **Gerätestecker mit nachgeschaltetem elektrischen Entstörfilter**
Appliance plug having an electrical-interference elimination filter connected thereto
Fiche d'appareil avec filtre électrique d'antiparasitage connecté à celle-ci

(30) Priorität: 04.09.1984 DE 3432491
(43) Veröffentlichungstag der Anmeldung: 19.03.1986
(73) Patentinhaber: SIEMENS AKTIENGESELLSCHAFT, 80333 München (DE)
(72) Erfinder: Dirmeyer, Josef, Dipl.-Ing. (FH), D-8465 Bodenwöhr (DE); Kathmann, Heinz, D-8400 Regensburg (DE); Merkle, Franz, D-8012 Ottobrunn (DE); Oberberger, Franz, D-8401 Mötzing (DE); Wilhelm, Walter, Dipl.-Ing. (FH), D-8411 Wenzenbach (DE); Wimmer, Josef, Dipl.-Ing., D-8413 Regenstauf (DE)

(56) Entgegenhaltungen:
- EP-A- 0 025 195
- EP-A- 0 113 465
- CH-A- 520 447
- CH-B- 557 583
- DE-A- 1 911 779
- DE-U- 6 601 390
- GB-A- 820 687
- US-A- 4 205 891
- Offenkundige Vorbenutzung nachgewiesen durch - Zeichnung 773, 28, 1531, Zeichnung FN 322
- EMC, Dietrer SGOU ISBN 3-87087-069-9, Elitera Verlag
- Elektromagnetische Verträglichkeit Bd 41, 1983, ISBN 3-88508-932-7
- "Elektronik Lexikon", Dr. Walter Baier, 1982, ISBN 3-440-05026-2
- SIEMENS Datenbuch EMV Funk-Entstörung Bauelemente, Filter 1983/84, Seite 240
- TN-Nachrichten, Heft 64, Jahrgang 1965, Seiten 8 und 9
- Zeichnung Nr. 231-021 Erdanschluss 05

## Beschreibung

Die Erfindung betrifft einen Gerätestecker mit nachgeschaltetem elektrischen Entstörfilter mit einem teils auf den Gerätestecker aufgeschobenen metallischen Filtergehäuse mit im Filtergehäuseinneren angeordneten, in Vergußmasse eingebetteten, teils an die netzseitigen Gerätesteckeranschlüsse und teils an zur Geräteseite gekehrte Anschlüsse angeschalteten elektrischen Filterbauelementen, insbesondere Induktivitäten und Kapazitäten, wobei die geräteseitigen Anschlüsse, insbesondere Flachstecker, Anschlußlitzen, Stiftstecker und dergleichen, an dem von dem Gerätestecker abgekehrten, teils offenen Stirnende des Filtergehäuses herausgeführt sind, und ein Schutzleiter über die gesamte Länge des Entstörfilters geführt und mit dem Filtergehäuse elektrisch leitend verbunden ist.

Die Entstörfilter der vorstehend genannten Art sind unter anderem für den Einsatz in Tischrechnern, Büromaschinengeräten und medizinischen Geräten bestimmt. Ihre wesentliche Aufgabe besteht dabei in der Verminderung ieitungsgebundener Störpegel. Da diese Filter bedingt durch ihre Verwendungsart durch ihre Einsatzumgebung hohen elektrischen und magnetischen Feldstärkepegeln ausgesetzt sind, ist darauf zu achten, daß ihre Entstörwirkung durch elektrische und magnetische Einkopplungen auf die Verdrahtung bzw. die Bauteile der Filterschaltung nicht gemindert wird. Insbesondere bei ihrem Einsatz in elektrischen Geräten mit Schaltnetzteilen und/oder Mikroprozessorsystemen mit ihren langen Busleitungen treten diese Probleme in hohem Maße auf. Soweit bereits Versuche unternommen wurden, um diese Probleme zu lösen, bestehen diese z. B. in der Verwendung allseitig geschlossener Metallgehäuse für die Entstörfilter, die isolierte Durchführungen für die Anschlüsse aufweisen. Als Metallgehäuse dienen dabei tiefgezogene Gehäuse aus Neusilber oder zweiteilige dicht verlötete Gehäuse aus Eisenblech.

Bekannt geworden sind solche Filter z. B. als Filter mit integriertem Kaltgerätestecker, bei denen die Anschlüsse von der Netzseite herüberdiesen Kaltgerätestecker - üblicherweise eine sogenannte Steckdose - und die Kontaktierung zum Gerät, das mit dem Filter zu versehen ist, über Flachstecker, Anschlußlitzen, Lötfahnen oder dergleichen erfolgen. Verwiesen sei hierzu beispielsweise auf die unter dem Titel « Elektromagnetische Verträglichkeit durch den Einsatz von Entstörfiltern » von Siemens herausgegebene technische Mitteilung aus dem Bereich Bauelemente, Bestell Nr. B/2418, insbesondere Seite 18 und auf den unter der Gestell Nr. B/2284 erhältlichen Siemens-Werbeprospekt« Funk-Entstörfilter »,Lieferprogramm 1980/81 S. 12, 13.

In eine Halbschale aus Neusilberblech sind dabei die Anschlüsse und die Träger der elektrischen Bauelemente dicht eingeklebt. Die elektrischen Bauelemente an sich werden bei diesem Entstörfilter in der Halbschale montiert, isoliert und von Hand eingelötet. Anschließend werden die elektrischen Bauelemente von der offenen Seite der Halbschale her zuerst mit einem weichen Epoxidharzverguß fixiert und anschließend durch einen Hartverguß mechanisch geschützt.

Weitere, im Handel erhältliche Entstörfilter verwenden anstelle der Neusilber-Halbschale ein tiefgezogenes Neusilber-Gehäuse. Die Bauelemente werden dabei in einem Hilfsrahmen mit flachen Steckern montiert und gelötet. Das Vergießen der Bauelemente und der im Filtergehäuse befindlichen Flachsteckerteile erfolgt durch ein Loch im Neusilbergehäuse, das dicht durch Beilegen von Dichtringen mit Stecker und Rahmen verbunden sein muß. Das Vergußloch ist durch ein aufgeklebtes Typenschild abgedeckt.

Gleichfalls im Handel erhältliche Entstörfilter benutzen ein gelötetes Mantelrohr aus Weißblech, wobei die elektrischen Bauelemente auf einer Trägerplatte montiert werden, die anschließend am Stecker angenietet wird. Das Anlöten des Masseanschlusses erfolgt durch ein Loch im Mantelrohr, das vorher auf den Stecker aufgeschoben werden muß. Die Lötstelle wird durch ein Typenschild abgedeckt. Der Verguß der elektrischen Bauelemente erfolgt dabei von der offenen Rückseite des Mantelrohres her.

Schließlich sind z. B. durch Siemens-Datenbuch 1982/84 « EMV Funk-Entstörung-Bauelemente, Filter », S. 240 Entstörfilter bekannt, die sich durch eine wirksame magnetische Schirmung und gute Hochfrequenzeigenschaften auszeichnen, mit verhältnismäßig geringem Aufwand herstellbarsind und die an diese Filter gestellten nationalen und internationalen Vorschriften erfüllen. Diese Filter besitzen ein Filtergehäuse mit in das Gehäuse eingesetzten und in Vergußmasse eingebetteten Induktivitäten und Kapazitäten, und elektrische Anschlüsse, insbesondere Flachstecker, Anschlußlitzen, Stiftstecker und dergleichen, die an offenen Stirnenden des Filtergehäuses herausgeführt und an die elektrischen Bauelemente angeschaltet sind. Das Filtergehäuse ist dabei derart verlängert, daß die nach außen gekehrten Anschlußelemente mindestens eines Anschlusses geschirmt innerhalb des Filtergehäuses angeordnet sind. Das Filtergehäuse kann zu diesem Zweck beispielsweise an seinen offenen Stirnenden schachtartig verjüngt sein.

Die Fertigung dieser Filter ist zwar bereits mit verhältnismäßig geringem Aufwand möglich ; sie erfordert dennoch manuelle Tätigkeiten, so zum Teil auch nur manuell durchführbare Lötungen und aufwendige Wickelvorgänge.

Die vorliegende Erfindung hat sich daher die Aufgabe gestellt, einen Gerätestecker, insbesondere IEC-Stecker, mit Entstörfilter gemäß der eingangs genannten Art zu schaffen, der unter Beibehaltung der den letztgenannten bekannten Entstörfiltern eigenen guten HF- und Schirmeigenschaften, sowie unter Erfüllung der entsprechenden nationalen und internationalen Vorschriften auf äußerst kostengünstige, d. h. insbesondere wenig aufwendige Weise herstellbar ist.

Dieser Aufgabe wird durch die Merkmale des Anspruches 1 gelöst.

Die Erfindung wird nachstehend anhand von Ausführungsbeispielen näher erläutert.

Es zeigt :
Fig. 1 in perspektivischer Darstellung ein erstes Ausführungsbeispiel nach der Erfindung eines Gerätesteckers mit nachgeschaltetem Entstörfilter, wobei zur Veranschaulichung die kapazitiven Filterbauelemente, der Verguß dieser Anordnung und das Filtergehäuse nicht gezeigt sind,
Fig. 2 eine gegenüber der Ausführung nach Fig. 1 lediglich in ihrem geräteseitigen Teil unterschiedliche Ausführung nach der Erfindung, weshalb nurdieserTeil perspektivisch und gebrochen dargestellt ist,
Fig. 3 in perspektivischer Darstellung ein Filtergehäuse für die Ausführungsbeispiele nach Fig. 1 und 2,
Fig. 4 in teils geschnittener Ansicht eine als Filterbauelement bestimmte, in einen Isolierstoffbehälter eingesetzte Ringkerndrossel.

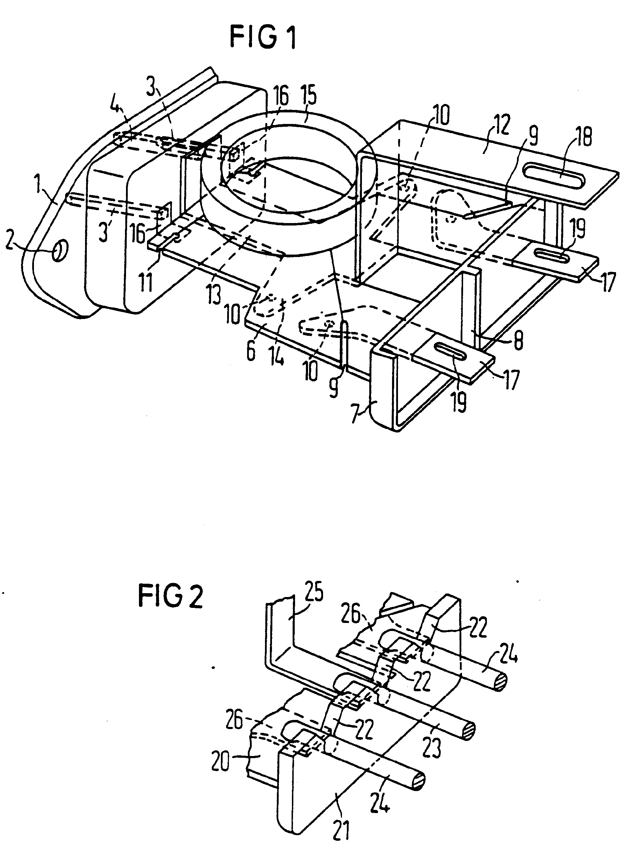

Die Fig. 1 zeigt einen Gerätestecker 1, insbesondere IEC-Stecker, mit seitlich angesetzten, mit Bohrungen 2 ausgerüsteten Laschen. Dieser an sich bekannte Stecker umschließt in den rückwärtigen Steckerteil eingebettete, stiftförmige elektrische Anschlußelemente 3 samt einem Schutzleiter 4.

Dem Gerätestecker 1 ist ein elektrisches Entstörfilter nachgeschaltet, von dessen elektrischen Filterbauelementen zur verbesserten Darstellung lediglich eine Ringkerndrossel 15 schematisch dargestellt ist. Das Entstörfilter ist zusätzlich mit einem X- und mit zwei Y- Kondensatoren bestückt, wovon nachstehend lediglich ihre Kontaktierungen mit den Anschlüssen erläutert sind.

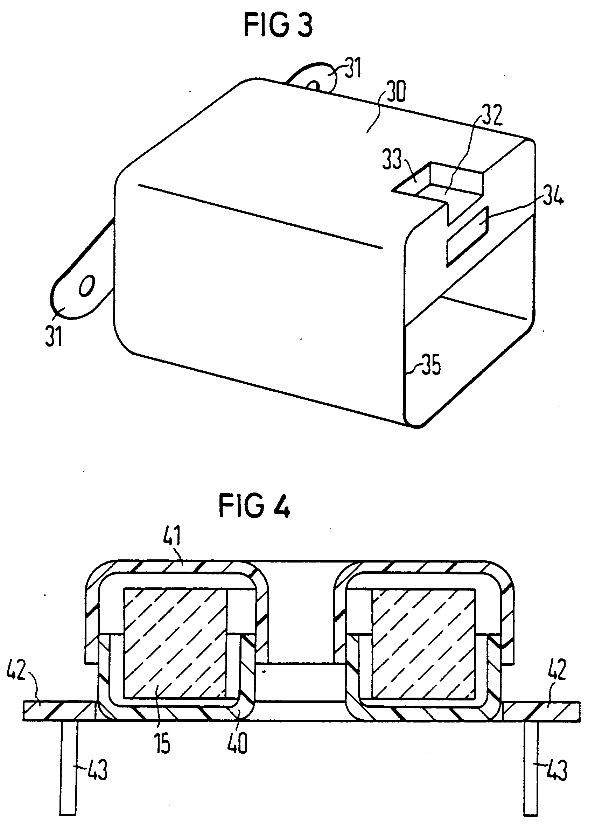

Mit 6 ist ein Isolierstoffplättchen bezeichnet, auf dessen einer Seite die elektrischen Filterbauelemente angeordnet sind und auf dessen anderer Seite ein breitflächiger und in diesem Bereich als kreuzförmiges Schutzleiterteil 13 gestalteter Schutzleitervorgesehen ist. Das Schutzleiterteil 13 liegt mit seinem einen abgewinkelten Ende gegen die Steckerrückwand an und ist dabei mit dem durch die Steckerrückwand geführten Stirnende des Schutzleiters 4 kontaktiert. Das hierzu gegenüberliegende Ende des Schutzleiterteils 13 ist gleichfalls abgewinkelt und im auf den Gerätestecker 1 aufgeschobenen Zustand des Filtergehäuses 30 nach Fig. 3 durch einen Schlitz 33 im Filtergehäuse nach außen geführt. Das Filtergehäuse 30, das im aufgesteckten Zustand mit seinen mit Bohrungen ausgerüsteten Laschen 31 gegen die entsprechenden Laschen des Gerätesteckers 1 anliegt und mittels durch die Bohrungen geführten Schrauben mit diesem verschraubt ist, besitzt zudem im Bereich des Schlitzes 33 eine Nut 32 auf der das Teil 12 des Schutzleiters teilweise aufliegt. Im fertigmontierten Zustand der gesamten Anordnung ist der Schutzleiter im Bereich dieser Nut 32 mittels Ultraschallschweißen mit dem Filtergehäuse 30 galvanisch verbunden.

Auf der Seite des Schutzleiterteils 13 liegen zusätzlich abgewinkelte Anschlußelemente 16 mit ihren einen Schenkeln auf, die mit ihren anderen Schenkeln mit den durch die Gerätesteckerrückwand geführten Stirnenden der elektrischen Anschlüsse 3 kontaktiert sind. Geräteseitig, d. h. auf der vom Gerätestecker 1 abgekehrten Seite des Isolierstoffplättchens 6 sind weitere elektrische Anschlüsse 17 angeordnet. Diese Anschlüsse liegen auf der Seite des Schutzleiterteils 13 teils auf dem Isolierstoffplättchen 6 auf, teils sind diese Anschlüsse durch eine an das Isolierstoffplättchen 6 angeformte Isolierstoff-Frontplatte 7 geführt. Ein zwischen den Anschlüssen 17 an die Frontplatte 7 einstückig angeformter Steg 8 gewährleistet zusätzlich die Einhaltung der erforderlichen Isolationsabstände zwischen den Anschlüssen 17. Zur Kontaktierung mit z. B. Drähten sind die Anschlüsse 17 und das Teil 12 des Schutzleiters zusätzlich mit Langlöchern 18 bzw. 19 ausgebildet.

Zur erleichterten Kontaktierung der gerätesteckerseitigen bzw. netzseitigen und der geräteseitigen Anschlüsse und des Schutzleiters mit den elektrischen Filterbauelementen sind die entsprechenden Teile der Anschlüsse 16, 17, die Enden 14 des kreuzförmigen Schutzleiterteils 13 und das Isolierstoffplättchen 6 teils mit Bohrungen 10 und teils mit randoffenen Schlitzen 9, 11 ausgestattet, die an ihren geschlossenen Enden zu Bohrungen erweitert sein können. Die Einführung der bevorzugt drahtförmigen Anschlußelemente der in der Zeichnung nicht dargestellten Wicklungen der Ringkerndrossel 15 und der gleichfalls nicht dargestellten X- und Y-Kondensatoren wird durch eine trichterförmige Gestaltung der Bohrungen 10 erleichtert.

Im fertigmontierten Zustand der elektrischen Filterbauelemente sind die Anschlüsse der Wicklungen der Ringkerndrossel 15 überdie Schlitze 9 bzw. 11 zu den Anschlüssen 17 bzw. zu den Elementen 16 geführt, der X-Kondensator mit seinen Anschlüssen auf die zu Bohrungen erweiterten Enden der Schlitze 11 aufgesteckt und die Y-Kondensatoren von den Bohrungen 10 der Anschlüsse 17 zu den Bohrungen 10 des Schutzleiterteils 13 geführt. Durch Tauchlöten läßt sich dabei die Kontaktierung in einem einzelnen Arbeitsgang bewerkstelligen.

Bei aufgestecktem Filtergehäuse 30, das bevorzugt aus Aluminium gezogen ist. sind die freien Enden der Anschlüsse 17 durch die Öffnung 35 im Filtergehäuse herausgeführt und das gesamte Filtergehäuseinnere in Vergußmasse eingebettet, die durch das Vergußloch 34 zugeführt wird.

Diese Anordnung, bestehend aus einem Gerätestecker mit nachgeschaltetem Entstörfilter, zeichnet sich durch seine geringen Abmessungen und durch seine wenig aufwendige Herstellung aus.

Anstelle der Flachsteckeranschlüsse und Schutzleiter 17 bzw. 12 gemäß Fig. 1 sind auch Stiftstecker und die in Fig. 2 gezeigten Anschlußlitzen 23, 24 möglich, die unmittelbar mit einem Schutzleiterteil 25 bzw. mit Anschlüssen 26 z. B. mittels Tauchlöten kontaktiert sind. Die Frontplatte 7 nach Fig. 1 ist dabei durch eine Frontplatte 21 ersetzt, die an ein Isolierstoffplättchen 20 entsprechend dem Isolierstoffplättchen 6 vorzugsweise einstückig angeformt ist, und Kerben 22 zur Aufnahme der Anschlußlitzen 23, 24 aufweist.

Die Fig. 4 zeigt eine mit geringstmöglichem Aufwand verbundene Möglichkeit zur getrennten Bewicklung der Ringkerndrossel 15, die anschließend auf die Isolierstoffplatte 6 bzw. 20 aufsteckbar und mittels Tauchlöten mit den entsprechenden Anschlüssen elektrisch kontaktierbar ist. Es entfällt folglich das bei der Ausführung nach Fig. 1 notwendige Einhängen der Wickelenden in die Schlitze 9,11. Die bereits bewickelte Ringkerndrossel 15 wird dabei in einen Isolierstoffbehälter eingesetzt, der aus zwei ineinandergesteckten kreisringförmigen Schalenhälften 40, 41 besteht. An die untere Schalenhälfte 40 sind Laschen 42 mit elektrischen Anschlußstiften 43 angeformt, an welche die Wickelenden beim abschließenden Wickelvorgang angewickelt werden. Das vorerwähnte Einhängen der Wickelenden in die Schlitze entfällt folglich.

## Patentansprüche

1. Gerätestecker (1) mit nachgeschaltetem elektrischen Entstörfilter, mit einem teils auf den Gerätestecker (1) aufgeschobenen metallischen Filtergehäuse (30), mit im Filtergehäuseinneren angeordneten, in Vergußmasse eingebetteten, teils an die netzseitigen Gerätesteckeranschlüsse (3,4) und teils an zur Geräteseite gekehrte Anschlüsse (17,12,23,24) angeschalteten elektrischen Filterbauelementen, insbesondere Induktivitäten und Kapazitäten, wobei die geräteseitigen Anschlüsse (17,12,23,24), insbesondere Flachstecker, Anschlußlitzen, Stiftstecker und dergleichen, an dem vom Gerätestecker abgekehrten, teils offenen Stirnende des Filtergehäuses (30) herausgeführt sind, und ein Schutzleiter (4,13,12) über die gesamte Länge des Entstörfilters geführt und mit dem Filtergehäuse (30) elektrisch leitend verbunden ist, dadurch gekennzeichnet, daß der Schutzleiter (4,13,12) breitflächig und im Filtergehäuseinneren als kreuzförmiges, als Trägereines Isolierstoffplättchens (6) dienendes Schutzleiterteil (13) gestaltet ist, dessen quer zur Schutzleiterlängsrichtung verlaufende Enden (14,14) mit Anschlüssen von Y-Kondensatoren verbunden sind, und daß das Isolierstoffplättchen (6) die durch dieses steckbaren Filterbauelemente (15) des Entstörfilters von dem Schutzleiterteil (13) trennt.

2. Gerätestecker nach Anspruch 1, dadurch gekennzeichnet, daß das Isolierstoffplättchen (6) auf der Seite des Schutzleiterteils (13) zusätzlich die zur Geräteseite gekehrten elektrischen Anschlüsse (17, 17) des Entstörfilters trägt.

3. Gerätestecker nach Anspruch 1, dadurch gekennzeichnet, daß das Isolierstoffplättchen (6) mit Bohrungen (10) und randoffenen Schlitzen (9, 11) ausgebildet ist, die zum Schutzleiterteil (13) bzw. zu den Enden der elektrischen Anschlüsse (16, 17) auf dem Isolierstoffplättchen führen.

4. Gerätestecker nach Anspruch 1, dadurch gekennzeichnet, daß als induktives Filterbauelement eine Ringkerndrossel (15) vorgesehen ist, die in einem Isolierstoffbehälter, bestehend aus zwei ineinander gesteckten kreisringförmigen Schalenhälften (40, 41), eingesetzt ist, und daß an die untere Schalenhälfte (40) Laschen (42) mit elektrischen Anschlußstiften (43) angeformt sind, die auf das Isolierstoffplättchen (6) aufsteckbar sind.

5. Gerätestecker nach Anspruch 4, dadurch gekennzeichnet, daß die untere Schalenhälfte (40) einstückig mit dem Isolierstoffplättchen (6) verbunden ist.

6. Gerätestecker nach Anspruch 1, dadurch gekennzeichnet, daß der Schutzleiter im Bereich seines geräteseitigen Endes (12) mittels Ultraschallschweißen unmittelbar mit dem Filtergehäuse (30) galvanisch verbunden ist.

## Claims

1. Apparatus plug (1) having an electrical interference-suppression filter connected downstream, having a metallic filter housing (30) which is partially pushed onto the apparatus plug (1), having electrical filter components, especially inductors and capacitors, which are arranged inside the filter housing, are embedded in potting compound are connected partially to the apparatus plug connections (3, 4) on the network side and are connected partially to connections (17, 12, 23, 24) facing towards the apparatus side, the connections (17, 12, 23, 24) on the apparatus side, especially flat plugs, connecting braided cables, pin plugs and the like, being led out on the partially open end of the filter housing (30) facing away from the apparatus plug, and an earth conductor (4, 13, 12) being passed over the entire length of the interference-suppression filter and being electrically conductively connected to the filter housing (30), characterised in that the earth conductor (4, 13, 12) has a broad surface and is designed inside the filter housing as a cruciform earth-conductor part (13) which is used as a support of an insulating-material platelet (6) and whose ends (14, 14) which run at right angles to the earth-conductor longitudinal direction are connected to connections of Y-capacitors, and in that the insulating-material platelet (6) separates the filter components (15) of the interference-suppression filter from the earth-conductor part (13), which filter components (15) can be plugged through said insulating-material platelet (6).

2. Apparatus plug according to Claim 1, characterised in that the insulating-material platelet (6) additionally carries the electrical connections (17, 17), facing the apparatus side, of the interference-suppression filter, on the side of the earth-conductor part (13).

3. Apparatus plug according to Claim 1, characterised in that the insulating-material platelet (6) is constructed with holes (10) and slots (9, 11) which are open at the edge and lead to the earth-conductor part (13) and to the ends of the electrical connections (16, 17) on the insulating-material platelet.

4. Apparatus plug according to Claim 1, characterised in that an annular-core inductor (15) is provided as the inductive filter component, which annular-core inductor (15) is inserted in an insulating-material container consisting of two circular- ring-shaped shell halves (40, 41) which can be plugged one inside the other, and in that flaps (42) having electrical connecting pins (43) are integrally formed on the lower shell half (40), which flaps (42) can be plugged onto the insulating-material platelet (6).

5. Apparatus plug according to Claim 4, characterised in that the lower shelf half (40) is integrally connected to the insulating-material platelet (6).

6. Apparatus plug according to Claim 1, characterised in that the earth conductor is directly connected, in DC terms, to the filter housing (30) in the region of its end (12) on the apparatus side, by means of ultrasound welding.

## Revendications

1. Socle connecteur d'appareil (1), en aval duquel est branché un filtre électrique d'antiparasitage, comportant un boîtier de filtre métallique (30) emmanché en partie sur le socle connecteur (1), et comportant des composants électriques du filtre, qui sont disposés à l'intérieur du boîtier de filtre, qui sont noyés dans une masse de scelleemnt et qui sont raccordés en partie aux bornes (3,4), situées du côté du réseau, du socle connecteur et en partie à des bornes (17, 12, 23, 24) situées du côté de l'appareil, notamment des inductances et des capacités, auquel cas les bornes (17,12,23, 24) situées du côté de l'appareil, notamment des fiches plates, des torons de raccordement, des connecteurs à broches et analogues, sont ressorties au niveau de l'extrémité frontale du boîtier de filtre (30), tournée à l'opposé du socle connecteur et partiellement ouverte, et un conducteur de protection (4, 13, 12) s'étend surtoute la longueur du filtre d'antiparasitage et est relié d'une manière électriquement conductrice au boîtier de filtre (30), caractérisé par le fait que le conducteur de protection (4, 13, 12) est réalisé de manière à avoir une surface étendue en largeur et est réalisé, à l'intérieur du boîtier de filtre, sous la forme d'un élément cruciforme (13), qui est utilisé comme support d'une plaquette en matériau isolant (6) et dont les extrémités (14, 14), qui s'étendent transversalement par rapport à la direction longitudinale du conducteur de protection, sont reliées à des bornes de condensateurs Y, et que la plaquette en matériau isolant (6) sépare les composants (15) du filtre d'antiparasitage, enfichables à travers cette plaquette, vis-à-vis de l'élément (13) du conducteur de protection.

2. Socle conducteur suivant la revendication 1, caractérisé par le fait que la plaquette en matériau isolant (6) supporte en outre, du côté de l'élément (13) du conducteur de protection, les bornes électriques (17, 17) du filtre d'antiparasitage, situées du côté de l'appareil.

3. Socle connecteur suivant la revendication 1, caractérisé par le fait que la plaquette en matériau isolant (6) est muni de perçages (10) et de fentes s'ouvrant latéralement (9, 11), qui aboutissent à l'élément (13) du conducteur de protection ou aux extrémités des bornes électriques (16, 17) sur la plaquette en matériau isolant.

4. Socle connecteur suivant la revendication 1, caractérisé par le fait qu'il est prévu, comme composant de filtre inductif, une bobine d'arrêt à noyau toroidal (15), qui est insérée dans un boîtier en matériau isolant constitué par deux moitiés de coque (40, 41) en forme d'anneaux circulaires, imbriquées l'une dans l'autre, et que sur la moitié de coque inférieure (40) se trouvent formées par façonnage des pattes (42) comportant des broches électriques de raccordement (43), qui peuvent être enfichées dans la plaquette en matériau isolant (6).

5. Socle connecteur suivant la revendication 4, caractérisé par le fait que la moitié de coque inférieure (40) est reliée d'un seul tenant à la plaquette en matériau isolant (6).

6. Socle connecteur suivant la revendication 1, caractérisé par le fait que le conducteur de protection est relié directement au boîtier de filtre (3) selon une liaison galvanique, au moyen d'un soudage par ultrasons, dans la zone de son extrémité (12) située du côté de l'appareil.
